# EUROPEAN PATENT APPLICATION

(11) **EP 4 503 371 A1**
(43) Date of publication of application: **05.02.2025**
(21) Application number: 23774204.4
(22) Date of filing: 17.01.2023
(51) Int. Cl.: H02J 7/00, B60L 3/00, B60L 58/10, H01M 10/48

(54) **MONITORING DEVICE, MONITORING METHOD, AND PROGRAM**

(30) Priority: 25.03.2022 JP 2022050535
(71) Applicant: HONDA MOTOR CO., LTD., Minato-ku Tokyo 107-8556 (JP)
(72) Inventor: INO, Mitsuyasu, Wako-shi, Saitama 351-0193 (JP); KOBAYASHI, Yoshiyuki, Wako-shi, Saitama 351-0193 (JP); SUZUKAWA, Yuki, Wako-shi, Saitama 351-0193 (JP); KOMATSU, Kazuki, Wako-shi, Saitama 351-0193 (JP); KOBAYASHI, Kosuke, Wako-shi, Saitama 351-0193 (JP); MOMAYA, Divyang, Wako-shi, Saitama 351-0193 (JP); KATO, Shinichiro, Wako-shi, Saitama 351-0193 (JP); KOBAYASHI, Naoki, Wako-shi, Saitama 351-0193 (JP)
(74) Representative: Weickmann & Weickmann PartmbB
(86) International application number: PCT/JP2023/001115
(87) International publication number: WO 2023/181603

(57) **Abstract**

A monitoring device includes: a receiver configured to receive a first signal which is output from a predetermined first device out of a plurality of devices connected to a communication line to the communication line; a transmitter configured to replace the received first signal with a second signal indicating an abnormality of the first device and to transmit the second signal to a second device other than the first device out of the plurality of devices; and a determiner configured to determine an adaptability of the second device to the first device based on reception of a third signal which is transmitted by the second device in response to reception of the second signal or reception of a fourth signal indicating that the first device enters a desired operation state in response to reception of the third signal.

## Description

### [Technical Field]

The present invention relates to a monitoring device, a monitoring method, and a program.

Priority is claimed on Japanese Patent Application No. 2022-050535, filed March 25, 2022, the content of which is incorporated herein by reference.

### [Background Art]

In the related art, there is a battery sharing system in which mobile batteries used for electric motorcycles or the like are shared by a plurality of users via a battery exchange station. In such a battery sharing system, the battery exchange station performs a user authentication process for authenticating a plurality of users (for example, see Patent Document 1).

### [Citation List]

### [Patent Document]

[Patent Document 1]
Japanese Unexamined Patent Application, First Publication No. 2021-78175

### [Summary of Invention]

### [Technical Problem]

When a mobile battery is applied to a device other than an electric motorcycle, it is necessary to test whether the target device matches requirements of the mobile battery. At this time, the test method needs to be simplified such that a manufacturer of the target device which is a party using the mobile battery can perform the test independently. However, in an adaptability test of a mobile battery according to the related art, a person with expertise needs to perform operation, ascertainment, and determination, and thus the manufacturer of the target device which is a party using the mobile battery may have difficulty performing the test independently.

The present invention was made in consideration of the aforementioned circumstances, and an objective thereof is to provide a monitoring device, a monitoring method, and a program with which an adaptability test of a mobile battery can be more easily performed.

### [Solution to Problem]

A monitoring device, a monitoring method, and a program according to the present invention employ the following configurations.

(1) A monitoring device according to an aspect of the present invention includes: a receiver configured to receive a first signal which is output from a predetermined first device out of a plurality of devices connected to a communication line to the communication line; a transmitter configured to replace the received first signal with a second signal indicating an abnormality of the first device and to transmit the second signal to a second device other than the first device out of the plurality of devices; and a determiner configured to determine an adaptability of the second device to the first device based on reception of a third signal which is transmitted by the second device in response to reception of the second signal or reception of a fourth signal indicating that the first device enters a desired operation state in response to reception of the third signal.
(2) The monitoring device according to the aspect of (1) further includes a storage configured to store a target signal which is a first signal to be replaced with the second signal in advance for each of a plurality of test items for simulating an abnormal state of the first device by replacing the first signal received from the first device with the second signal, and the transmitter replaces the target signal with the second signal corresponding to a test item when the target signal for each test signal is received.
(3) In the aspect of (2), the storage stores a plurality of second signals with which the target signal is to be replaced for each test item and the third signal which is to be transmitted from the second device in response to reception of the second signal in advance, and the determiner determines that the second device is adaptable to the first device by receiving the third signal to be received from the second device for each test item.
(4) In any one of the aspects of (1) to (3), the first device is a battery and the second device is an electric device that operates with electric power supplied from the battery, and the determiner determines that the second device is adaptable to the first device when the second signal is a signal indicating an overloaded state of the battery and the third signal is a control signal for decreasing a load of the battery.
(5) The monitoring device according to the aspect of (2) further includes a detector configured to detect an operation state of the first device, and the storage stores an operation state suitable for the first device for each test item in advance, and the determiner determines that the second device is adaptable to the first device when the detector detects that the first device is in the suitable operation state for each test item.
(6) A monitoring method according to another aspect of the present invention is performed by a computer and includes: receiving a first signal which is output from a predetermined first device out of a plurality of devices connected to a communication line to the communication line; replacing the received first signal with a second signal indicating an abnormality of the first device and transmitting the second signal to a second device other than the first device out of the plurality of devices; and determining an adaptability of the second device to the first device based on reception of a third signal which is transmitted by the second device in response to reception of the second signal or reception of a fourth signal indicating that the first device enters a desired operation state in response to reception of the third signal.
(7) A program according to another aspect of the present invention is a program causing a computer to perform: receiving a first signal which is output from a predetermined first device out of a plurality of devices connected to a communication line to the communication line; replacing the received first signal with a second signal indicating an abnormality of the first device and transmitting the second signal to a second device other than the first device out of the plurality of devices; and determining an adaptability of the second device to the first device based on reception of a third signal which is transmitted by the second device in response to reception of the second signal or reception of a fourth signal indicating that the first device enters a desired operation state in response to reception of the third signal.

### [Advantageous Effects of Invention]

According to the aspects of (1) to (7), by receiving a first signal which is output from a predetermined first device out of a plurality of devices connected to a communication line to the communication line, replacing the received first signal with a second signal indicating an abnormality of the first device and transmitting the second signal to a second device other than the first device out of the plurality of devices, and determining an adaptability of the second device to the first device based on reception of a third signal which is transmitted by the second device in response to reception of the second signal or reception of a fourth signal indicating that the first device enters a desired operation state in response to reception of the third signal, it is possible to more easily perform an adaptability test of a mobile battery.

### [Brief Description of Drawings]

FIG. 1 is a diagram illustrating a connection configuration of a detachable battery and a target device in a normal state.
FIG. 2 is a diagram illustrating a connection configuration of the detachable battery and the target device in an adaptability test.
FIG. 3 is a diagram illustrating an example of a configuration of a detachable battery.
FIG. 4 is a diagram illustrating an example of a configuration of an electric motorcycle.
FIG. 5 is a diagram illustrating an example of a configuration of a monitoring device.
FIG. 6 is a diagram illustrating an example of a test item list.
FIG. 7 is a diagram illustrating an example of a user interface that is provided in the monitoring device.
FIG. 8 is a diagram illustrating details of a connection configuration of a detachable battery and an OEM device and the monitoring device.
FIG. 9 is a diagram schematically illustrating an adaptability test using the monitoring device.
FIG. 10 is a flowchart illustrating an example of a process flow that is performed by the monitoring device in an adaptability test.
FIG. 11 is a diagram illustrating an example of a result of an adaptability test.
FIG. 12 is a diagram illustrating an example of a timing chart of signals which are input and output to and from the monitoring device at the time of testing of a plurality of detachable batteries.

### [Description of Embodiments]

Hereinafter, a monitoring device, a monitoring method, and a program according to an embodiment of the present invention will be described below with reference to the accompanying drawings.

### [1. Outline]

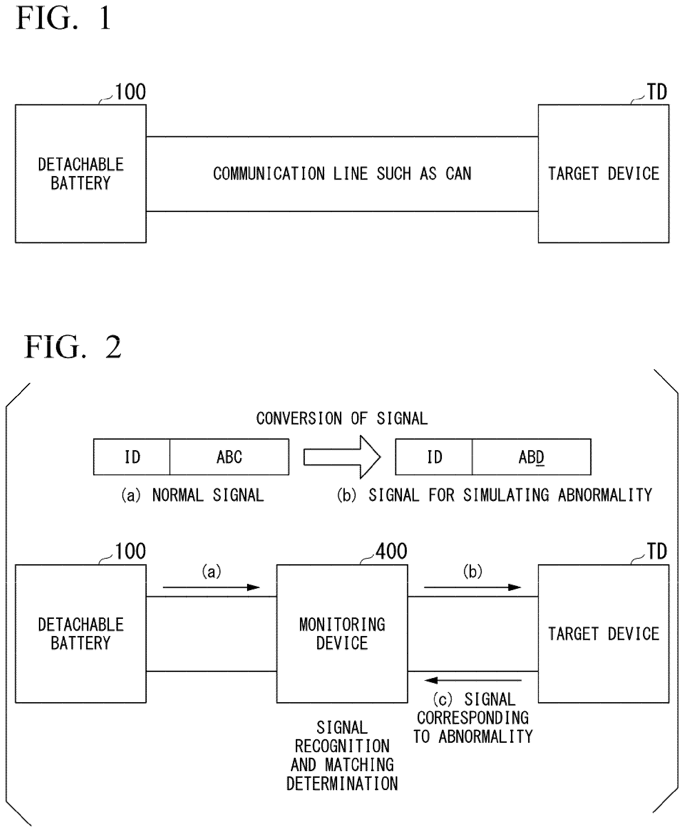

FIGS. 1 and 2 are diagrams illustrating an outline of an adaptability test of a detachable battery 100 according to an embodiment. Specifically, FIG. 1 is a diagram illustrating a connection configuration of the detachable battery 100 and a target device TD which is a device to be tested in a normal state. FIG. 2 is a diagram illustrating a connection configuration of the detachable battery 100 and the target device TD in an adaptability test. As illustrated in FIG. 1, in a normal state, the detachable battery 100 is used as a power source of a target device TD through control communication via a communication line such as a controller area network (CAN) communication line. A monitoring device 400 according to this embodiment is a device that supports an adaptability test of the detachable battery 100 to such a target device TD. As illustrated in FIG. 2, the monitoring device 400 according to this embodiment is connected between the detachable battery 100 and the target device TD and relays transmission and reception of control signals between the detachable battery 100 and the target device TD.

More specifically, the monitoring device 400 determines an adaptability of a detachable battery 100 to the target device TD by monitoring signals which are input and output between the detachable battery 100 and the target device TD in the adaptability test and determining validity thereof. In the adaptability test, the monitoring device 400 outputs an output signal (a) of the detachable battery 100, converts the output signal (a) to a signal (b) corresponding to a test item, and outputs the signal (b) to the target device TD, and the target device TD can output a signal (c) based on the signal (b). For example, the signal (a) is a normal signal, the signal (b) is a signal for simulating an abnormality of the detachable battery 100, and the signal (c) is a signal corresponding to an abnormality indicated by the signal (b). Accordingly, a test operator does not need to actually change a state of the detachable battery 100 to a state based on a test item and thus can perform an adaptability test in a simpler sequence. With this configuration, since a test can be automated, it is possible to decrease a cost for the test. By automating the test, even a person without expertise can perform the adaptability test. The configuration of the monitoring device 400 that can achieve such advantages will be described below in detail.

### [2. Configuration of detachable battery]

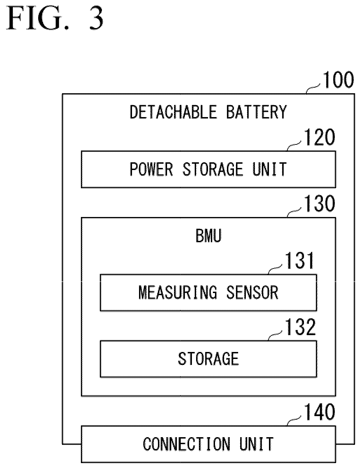

FIG. 3 is a diagram illustrating an example of a configuration of a detachable battery 100. The detachable battery 100 includes, for example, a power storage unit 120, a BMU 130, and a connection unit 140. The BMU 130 includes, for example, a measuring sensor 131 and a storage 132. The power storage unit 120 is, for example, a battery pack in which a plurality of unit batteries are connected in series. Each unit battery constituting the power storage unit 120 is, for example, a secondary battery that can repeat charging and discharging such as a lithium-ion battery (LIB), a nickel-hydride battery, or an all-solid-state battery. Examples of each secondary battery constituting the power storage unit 120 may include a capacitor such as an electric double-layer capacitor and a complex battery in which a secondary battery and a capacitor are combined in addition to a lead storage battery and a sodium-ion battery. The configuration of each secondary battery constituting the power storage unit 120 is not particularly limited.

The BMU 130 performs charging or discharging control of the power storage unit 120, cell balancing, abnormality detection of the power storage unit 120, derivation of a cell temperature of the power storage unit 120, derivation of a charging/discharging current of the power storage unit 120, estimation of an SOC of the power storage unit 120, and the like. The BMU 130 stores a measurement result of the measuring sensor 131, an abnormality or a failure of the power storage unit 120 ascertained based on the measurement result, and the like as battery state information in the storage 132. The measuring sensor 131 includes a voltage sensor, a current sensor, and a temperature sensor for measuring a state of charge of the power storage unit 120. The measuring sensor 131 outputs measurement results such as the measured voltage, current, and temperature to the BMU 130. A detachable battery 100 in which a predetermined time or longer has elapsed from a previous operation end time may be defined as a detachable battery 100 which does not operate electrically. A detachable battery 100 other than the detachable battery 100 defined as described above may be defined as a detachable battery 100 which operates electrically. The electrically operating state may be defined as, for example, one of a state in which the detachable battery 100 is charged and a state in which the detachable battery 100 is discharged. The BMU 130 may record information in which a measured value and a measurement time are correlated as a measurement result of the measuring sensor 131 in the storage 132 or may record information in which a measured value and a measurement frequency are correlated (a so-called histogram) in the storage 132.

The storage 132 includes, for example, a nonvolatile storage device such as a hard disk drive (HDD), a solid state drive (SSD), or a flash memory. The storage 132 stores the battery state information. Identification information (a battery ID) assigned to the detachable battery 100 may be stored in the storage 132. The connection unit 140 is electrically connected to a battery connection unit 210 of an electric motorcycle 200 when a detachable battery 100 is attached to the electric motorcycle 200. In this state, the detachable battery 100 supplies electric power stored in the power storage unit 120 to an electric motor provided in the electric motorcycle 200.

### [3. Configuration of electric motorcycle]

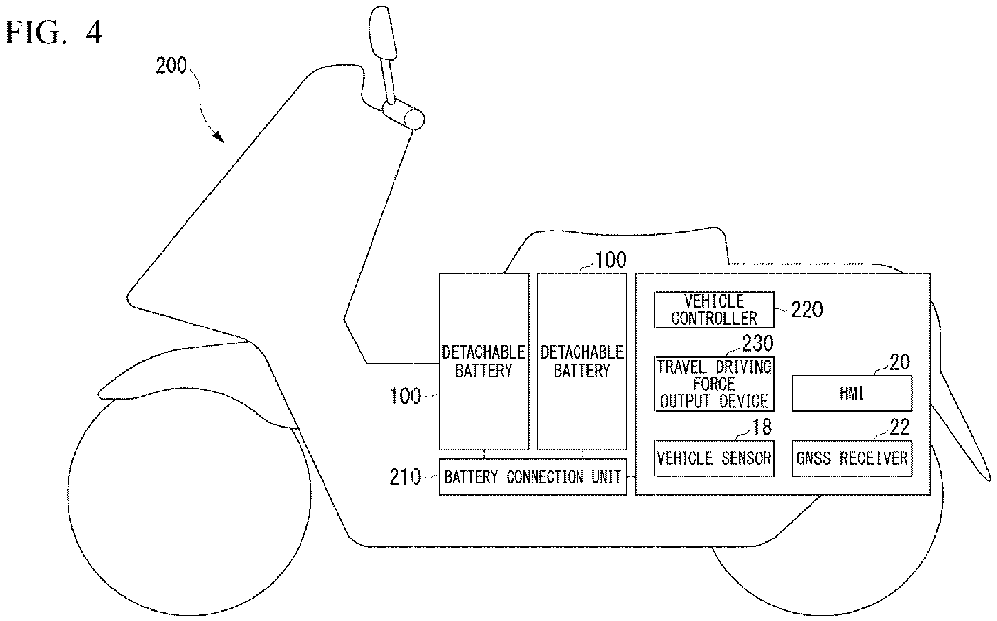

FIG. 4 is a diagram illustrating an example of a configuration of an electric motorcycle 200. The electric motorcycle 200 travels with a driving force of a motor (an electric motor) that is driven with electric power supplied from a detachable battery 100. Here, the electric motorcycle 200 may be a hybrid electric vehicle that travels with a driving force based on a combination of a detachable battery 100 and an internal combustion engine such as a diesel engine or a gasoline engine. The electric motorcycle 200 includes, for example, a battery connection unit 210, a vehicle controller 220, a travel driving force output device 230, a vehicle sensor 18, a human-machine interface (HMI) 20, and a global navigation satellite system (GNSS) receiver 22.

The battery connection unit 210 is electrically connected to a detachable battery 100 when the detachable battery 100 is attached to the electric motorcycle 200. The battery connection unit 210 includes a connection terminal of a power line for supplying electric power from the detachable battery 100 and a connection terminal of a communication line for transmitting data between the detachable battery 100 and the vehicle controller 220.

The vehicle controller 220 acquires measurement results from the vehicle sensor 18, acquires various types of information on the power storage unit 120 (for example, an SOC or a DOD) from a battery management unit (BMU) 110 provided in the detachable battery 100, and acquires a position of the electric motorcycle 200 from the GNSS receiver 22. The vehicle controller 220 controls the travel driving force output device 230 based on the acquired data. The vehicle controller 220 may transmit position information of the electric motorcycle 200 acquired from the GNSS receiver 22 to the detachable battery 100 via the battery connection unit 210.

The vehicle controller 220 has a function of acquiring information on usage limit (hereinafter referred to as "limit information") of the detachable battery 100 from the detachable battery 100 attached to the electric motorcycle 200 and limiting usage of the detachable battery 100 based on the limit information. The usage limit of the detachable battery 100 will be described later.

The travel driving force output device 230 includes, for example, an electric motor, an inverter, and an electronic control unit (ECU) that controls the inverter. The ECU controls electric power supplied from the detachable battery 100 to the electric motor, for example, by controlling the inverter. The vehicle sensor 18 includes various types of sensors including a speed sensor, an acceleration sensor, a rotation speed sensor, and an odometer mounted in the electric motorcycle 200. The vehicle sensor 18 outputs the measurement results to the vehicle controller 220.

The HMI 20 outputs various types of information to a user of the electric motorcycle 200 and receives an input operation from a user. The HMI 20 includes, for example, various types of display devices (which may include a touch panel) such as a head-up display (HUD) and a meter display and a speaker. The GNSS receiver 22 measures a position of the electric motorcycle 200, for example, based on radio waves received from GNSS satellites (such as global positioning system (GPS) satellites).

The electric motorcycle 200 described above is an example of a target device TD. Like the electric motorcycle 200, the target device TD is a device that operates with electric power supplied from a detachable battery 100 and can transit and receive electric power or manage or record a state of the detachable battery 100 by performing control communication with the detachable battery 100. The monitoring device 400 determines an adaptability of the detachable battery 100 to the target device TD by monitoring and simulating control communication between the target device TD and the detachable battery 100.

### [4. Configuration of monitoring device]

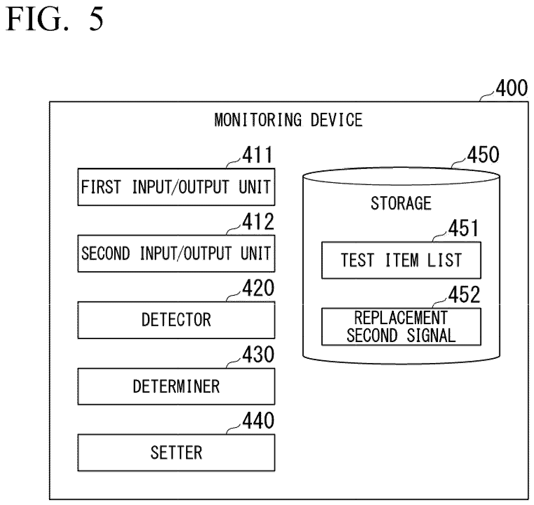

FIG. 5 is a diagram illustrating an example of a system configuration of the monitoring device 400. The monitoring device 400 includes, for example, a first input/output unit 411, a second input/output unit 412, a detector 420, a determiner 430, a setter 440, and a storage 450. These constituents are realized, for example, by causing a hardware processor such as a central processing unit (CPU) to execute a program (software). Some or all of these constituents may be realized by hardware (a circuit unit which includes circuitry) such as a large scale integration (LSI) device, an application-specific integrated circuit (ASIC), a field-programmable gate array (FPGA), or a graphics processing unit (GPU) or may be cooperatively realized by software and hardware. The program may be stored in a storage device (a storage device including a non-transitory storage medium) such as an HDD, an SSD, or a flash memory in advance or may be stored in a detachable storage medium (a non-transitory storage medium) such as a DVD or a CD-ROM and installed by setting the storage medium into a drive device.

The first input/output unit 411 inputs and outputs signals between the detachable battery 100 and the monitoring device 400. The second input/output unit 412 inputs and outputs signals between a target device TD to be tested and the monitoring device 400. The first input/output unit 411 and the second input/output unit 412 have a function of inputting and outputting a control signal and a function of inputting and outputting electric power. The first input/output unit 411 and the second input/output unit 412 simulate a communication line directly connected between the detachable battery 100 and the target device TD by relaying signals which are input and output between the detachable battery 100 and the target device TD. Here, the second input/output unit 412 replaces a control signal (hereinafter referred to as a "first signal") received from the detachable battery 100 with a control signal (hereinafter referred to as a "second signal") indicating an abnormality of the detachable battery 100 (which is an example of a first device) for each test item in the adaptability test and outputs the second signal to the target device TD (which is an example of a second device). Here, the first signal to be replaced with the second signal based on each test item is an example of a "target signal." Here, the second input/output unit 412 outputs a signal not associated with a test item to the target device TD in a pass-through manner without replacing the signal not associated with a test item. Here, the first input/output unit 411 is an example of a "receiver," and the second input/output unit 412 is an example of a "transmitter."

The detector 420 detects an operation state of the detachable battery 100. For example, the detector 420 can detect the operation state of the detachable battery 100 based on a first signal which is input from the CAN of the detachable battery 100.

The determiner 430 determines an adaptability of the target device TD to the detachable battery 100 based on reception of a third signal which is transmitted from the target device TD in response to reception of a second signal or reception of a fourth signal indicating that the detachable battery 100 has become a desired operation state in response to reception of the third signal.

The setter 440 sets a plurality of test items for a test for simulating an abnormality state of the detachable battery 100 by causing the second input/output unit 412 to replace the first signal with the second signal.

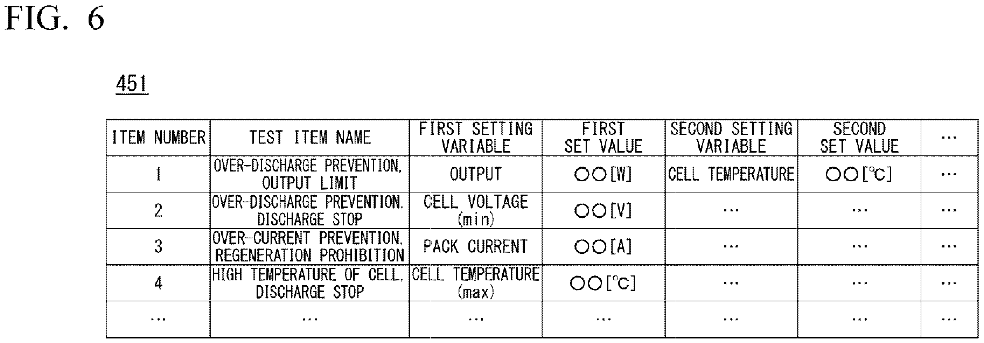

FIG. 6 is a diagram illustrating an example of test items which are set by the setter 440. For example, the setter 440 prepares a test item list 451 illustrated in FIG. 6. In the test item list illustrated in FIG. 6, an item number, a test item name, a first setting variable name, a first set value, a second setting variable name, and a second set value are correlated with each other. The first set value is a value that is set as a variable associated with the first setting variable name. The second set value is a value that is set as a variable associated with the second setting variable name. In the example illustrated in FIG. 6, settable variables in the items include a first setting variable and a second setting variable, but the number of settable variables in the items may be one or three or more.

Description will be continued with reference back to FIG. 5. The storage 450 includes, for example, a nonvolatile storage device such as an HDD, an SSD, or a flash memory. The storage 450 is used as a storage area for various types of information on the operation of the monitoring device 400. For example, information 451 indicating the test item list or a replacement second signal 452 which is a second signal corresponding to the first signal to be replaced is stored in the storage 450. As the replacement second signal 452, the second signal varying depending on the test items can be set.

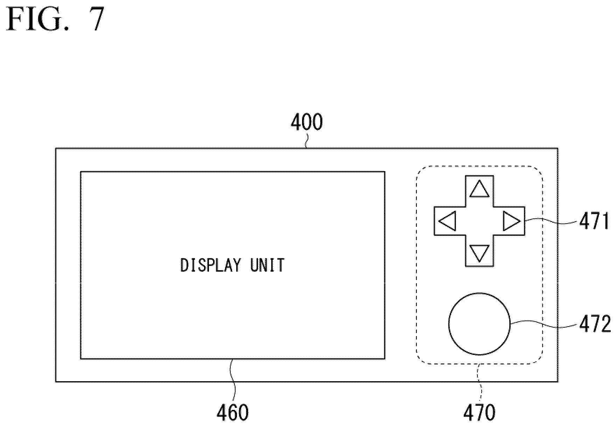

FIG. 7 is a diagram illustrating an example of a user interface provided in the monitoring device 400. The monitoring device 400 includes a display unit 460 that displays information and an operation input unit 470 such as a cross key 471 and a button 472. The display unit 460 is constituted by a display device such as a liquid crystal display or an organic electro-luminescence (EL) display. On the display unit 460, various types of information on the adaptability test are displayed according to the operations of the first input/output unit 411, the second input/output unit 412, the determiner 430, the setter 440, and the like.

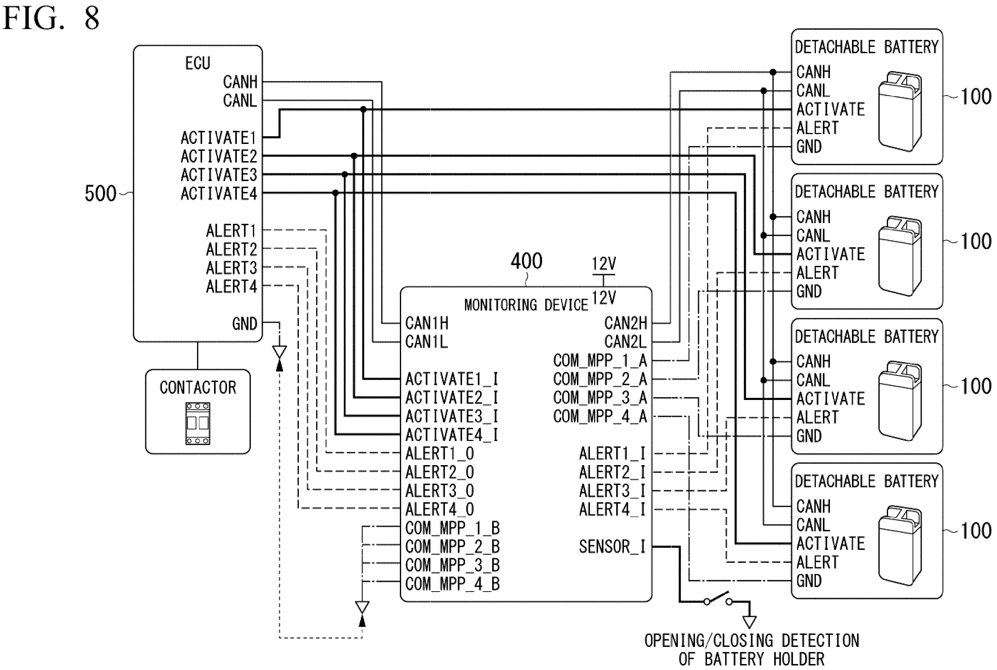

FIG. 8 is a diagram illustrating details of a connection configuration between a detachable battery 100 and a target device TD and the monitoring device 400. For example, it is assumed that the monitoring device 400 monitors signals transmitted between four detachable batteries 100 and an ECU 500 of the target device TD. In the example illustrated in FIG. 8, the ECU 500 includes two interfaces (CANH and CANL) for inputting and outputting a CAN signal, four interfaces (ACTIVATE1 to ACTIVATE4) for inputting and outputting an activation signal, four interfaces (ALERT1 to ALERT4) for inputting and outputting an alert signal, and a ground interface (GND). The four detachable batteries 100 include two interfaces (CANH and CANL) for inputting and outputting a CAN signal, an interface (ACTIVATE) for inputting and outputting different activation signals for four activation signals (ACTIVATE1 to ACTIVATE4), an interface (ALERT) for inputting and outputting different alert signals for four alert signals (ALERT1 to ALERT4), and a ground interface (GND).

In a normal state, the corresponding interfaces of each detachable battery 100 and the ECU 500 are directly connected to each other. On the other hand, in an adaptability test, the corresponding interfaces of each detachable battery 100 and the ECU 500 are connected via the monitoring device 400. Accordingly, the monitoring device 400 in the example illustrated in FIG. 8 includes the first input/output unit 411 including an interface group connected to the interfaces of the ECU 500 and the second input/output unit 412 including an interface group connected to the interfaces of four detachable batteries 100. The monitoring device 400 may include other interfaces based on the items of the adaptability test in addition to the aforementioned interfaces. For example, in the example illustrated in FIG. 8, the monitoring device 400 includes an interface (SENSOR_I) for inputting a signal of a sensor that detects an open/closed state of a connector (a battery holder) for connecting the detachable batteries 100 to the host device.

It is assumed that the monitoring device 400 has performance sufficient for simulating a state in which a target device TD and a detachable battery 100 are directly connected in the state in which the target device TD and the detachable battery 100 have been connected. More specifically, when the first signal does not have to be replaced with the second signal, the monitoring device 400 realizes a state in which the interface of the target device TD and the interface of the detachable battery 100 are directly electrically connected. When the first signal has to be replaced with the second signal, the monitoring device 400 is configured to have processing performance capable of decreasing a delay due to replacement of a signal such that communication requirements between the target device TD and the detachable battery 100 are satisfied.

For example, in the monitoring device 400, the first input/output unit 411 and the second input/output unit 412 connecting the target device TD and the detachable battery 100 are configured such that the target device TD side and the detachable battery 100 side do not have to perform a change to a connector, a harness, or the like. For example, the monitoring device 400 is configured such that a time loss in transmission of signals between the CAN of the target device TD and the CAN of the detachable battery 100 is equal to or less than half a shortest period of a periodic signal in the CAN communication. This is because it is necessary to complete previous communication before next communication comes in reproduction of the direct connected state via the CAN. Therefore, the monitoring device 400 according to the embodiment provides a margin such that the time loss is equal to or less than half the shortest period in consideration of the likelihood that a delay in the CAN communication protocol will occur. In the adaptability test using the monitoring device 400 according to the embodiment, since rewriting of software in the target device TD and the detachable battery 100 or the like is not necessary, even a person without expertise can perform the adaptability test.

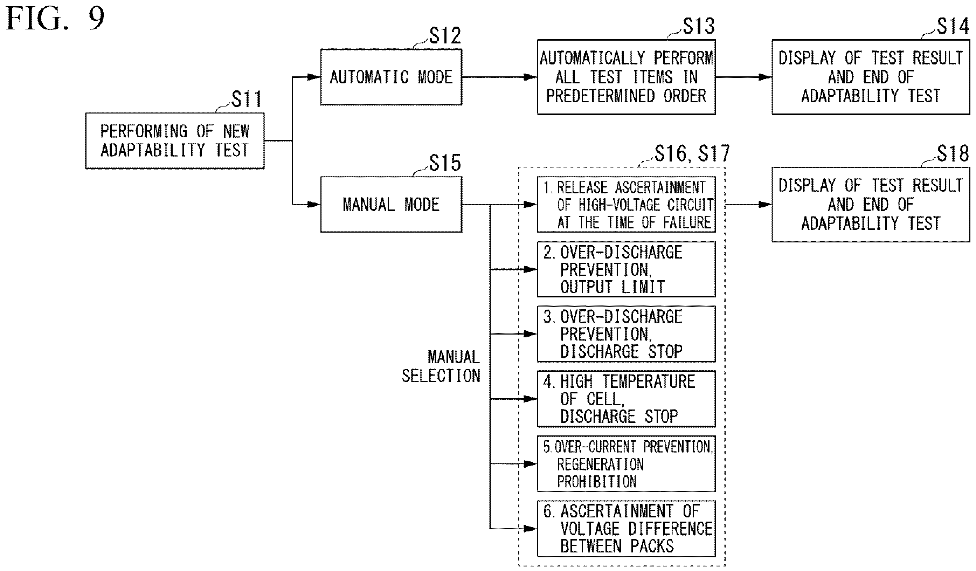

FIG. 9 is a diagram schematically illustrating an adaptability test using the monitoring device 400. Here, it is assumed that the monitoring device 400 is electrically connected to the target device TD and the detachable battery 100 and is in a state in which an operation input for the adaptability test can be received at the start point of the process flow. First, the monitoring device 400 receives an operation for performing a new adaptability test (S11: performing of new test). Subsequently, the monitoring device 400 receives an operation of selecting in what test mode of an automatic mode and a manual mode the test is to be performed. The automatic mode is a test mode in which all the test items are automatically performed in a predetermined order. The manual mode is a test mode in which a user is made to select a test item to be performed and to perform the selected test item.

When the automatic mode is selected (Step S12), the monitoring device 400 automatically performs all the test items in the predetermined order while displaying the item number, the item name, an error of the test, or the like along the flow of the test (Step S13). When performing of all the test items ends, the monitoring device 400 displays the test result and ends the adaptability test (Step S14).

On the other hand, when the manual mode is selected (Step S15), the monitoring device 400 receives an operation of selecting a test item to be performed (Step S16). The monitoring device 400 performs the selected test item while displaying the item number, the item name, an error, or the like for the selected test item (Step S17). When manual performing of the test ends, the monitoring device 400 displays the test result and ends the adaptability test (Step S18). The monitoring device 400 may determine which of passing and failure the test result indicates based on predetermined evaluation criteria. When the test result indicates failure, the monitoring device 400 may notify a user of a reason thereof (such as an error code) by displaying the reason or the like.

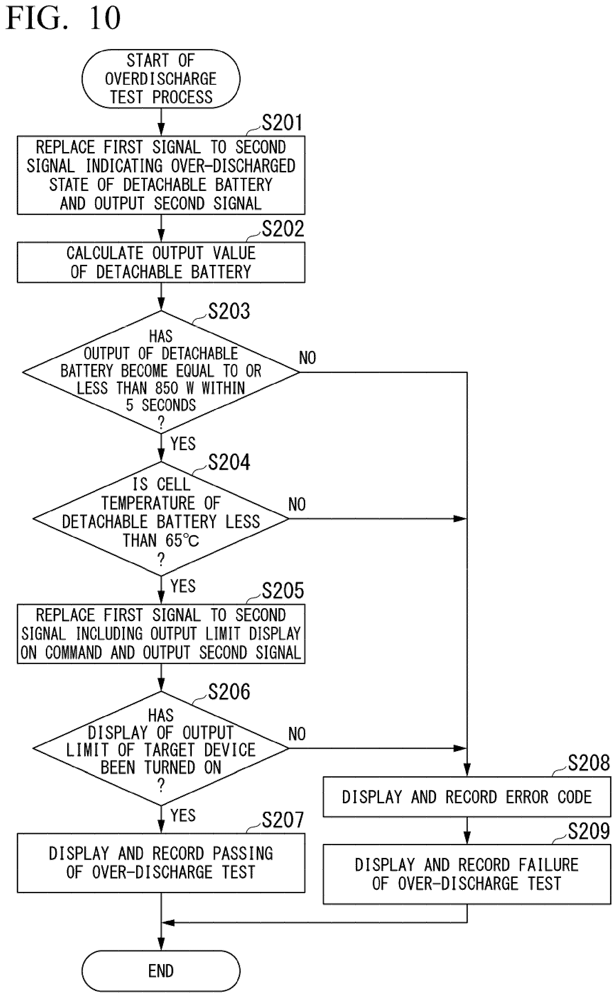

FIG. 10 is a flowchart illustrating an example of a process flow that is performed in an adaptability test by the monitoring device 400. Here, an example of test items (hereinafter referred to as an "over-discharge test") for verifying the operation of a target device TD at the time of over-discharge of a detachable battery 100 will be described. First, when the first input/output unit 411 in the monitoring device 400 receives a first signal from the detachable battery 100, the second input/output unit 412 replaces the first signal with a second signal indicating an over-discharged state of the detachable battery 100 and outputs the second signal to the CAN of the target device TD (Step S201). When the second signal is input, the target device TD can recognize the over-discharged state of the detachable battery 100. In this case, the target device TD is expected to output a third signal including an output limit command for relaxing the over-discharged state of the detachable battery 100 to the detachable battery 100 via the monitoring device 400. The over-discharged state is an example of an "overloaded state." The output limit command is an example of a "control signal for decreasing a load of a battery."

Subsequently, the first input/output unit 411 in the monitoring device 400 receives information of an output voltage and an output current of the detachable battery 100 from the CAN of the detachable battery 100 and calculates an output value of the detachable battery 100 based on the received information (Step S202). The first input/output unit 411 continuously performs calculation of the output value based on the information of the output voltage and the output current which is received from time to time, and the detector 420 monitors an output (an example of an operation state) of the detachable battery 100 based on the calculation result and notifies the determiner 430 when a predetermined output is detected.

Subsequently, the determiner 430 determines whether the output of the detachable battery 100 has become equal to or less than 850 W within 5 seconds in response to outputting of the output limit command (Step S203). For example, the determiner 430 performs the determination based on whether a notification has been received from the detector 420. Here, when it is determined that the output of the detachable battery 100 has become equal to or less than 850 W within 5 seconds, the determiner 430 subsequently determines whether the cell temperature of the detachable battery 100 is lower than 65°C (Step S204). At this time, the first input/output unit 411 receives information of the cell temperature of the detachable battery 100 from the CAN of the detachable battery 100, and the detector 420 can recognize the cell temperature (an example of the operation state) of the detachable battery 100 based on the received information. When the cell temperature equal to or higher than a predetermined value has been detected, the detector 420 transmits a notification thereof to the determiner 430. For example, the determiner 430 performs the determination based on whether a notification has been received from the detector 420.

Here, when it is determined that the cell temperature of the detachable battery 100 is lower than 65°C, the second input/output unit 412 subsequently replaces the first signal with a second signal including an output limit display-on command for a meter of the target device TD and outputs the second signal to the CAN of the target device TD (Step S205), and the determiner 430 determines whether an output limit display has been turned on in the target device TD (Step S206). Here, when it is determined that the output limit display has been turned on in the target device TD, the determiner 430 displays a notification indicating that the target device TD has passed the over-discharge test and records the notification in the test result (Step S207), and ends this series of processes.

On the other hand, when it is determined in Step S203 that the output of the detachable battery 100 is not equal to or less than 850 W within 5 seconds, the determiner 430 displays an error code indicating that notification and records the error code in the test result (Step S208). Subsequently, the determiner 430 displays a notification indicating that the target device TD has failed the over-discharge test, records the notification in the test result (Step S209), and ends this series of processes.

On the other hand, when it is determined in Step S204 that the cell temperature of the detachable battery 100 is not lower than 65°C (that is, is equal to or higher than 65°C), the determiner 430 displays an error code indicating the determination result and records the error code in the test result (Step S208). Subsequently, the determiner 430 displays a notification indicating that the target device TD has failed the over-discharge test and records the notification in the test result (Step S209) and ends this series of processes.

On the other hand, when it is determined in Step S206 that the output limit display has not been turned on in the target device TD (that is, the output limit display is maintained off), the determiner 430 displays an error code indicating the notification and records the error code in the test result (Step S208). Subsequently, the determiner 430 displays a notification indicating that the target device TD has failed the over-discharge test and records the notification in the test result (Step S209) and ends this series of processes.

When the output of the detachable battery 100 has become equal to or less than 850 W within 5 seconds after Step S201, it means that the output limit command functions (is output) normally. That is, the determiner 430 determines that the target device TD is adaptable to the detachable battery 100 when the second signal is a signal indicating an over-discharged state of the detachable battery 100 and the third signal is a control signal for decreasing the load of the detachable battery 100. That is, the determiner 430 determines whether the target device TD can appropriately control the detachable battery 100 based on the over-discharged state of the detachable battery 100. When the target device TD can appropriately control an overloaded state of the detachable battery 100, the determiner 430 may determine that the target device TD is adaptable to the detachable battery 100.

At this time, the determiner 430 may determine whether the target device TD is to output the third signal instead of/in addition to ascertaining whether the output of the detachable battery 100 is to be decreased. For example, in this case, a plurality of second signals with which the first signal is to be replaced according to the test items and the third signal to be transmitted from the target device TD in response to reception of the second signal are stored in the storage 450 in advance. The determiner 430 can determine whether the target device TD is to output the third signal by acquiring the third signal corresponding to the received second signal from the storage 450 and comparing the acquired third signal with the third signal actually input from the target device TD. When the target device TD has output the output limit command to the detachable battery 100 in the over-discharged command, the determiner 430 may determine that the target device TD is adaptable to the detachable battery 100.

In other words, the adaptability determining method is determining that the target device TD is adaptable to the detachable battery 100 when it is detected that the detachable battery 100 is in an operation state appropriate for a test item for each test item. In this case, a first signal indicating the operation state appropriate for the detachable battery 100 for each test item is stored in the storage 450 in advance. Then, the detector 420 detects that the detachable battery 100 is in the appropriate operation state and notifies the determiner 430 by comparing the first signal based on the test item stored in advance in the storage 450 with the first signal actually input from the detachable battery 100, and the determiner 430 can perform the determination based on whether a notification has been received from the detector 420. The function of the detector 420 may be provided as a part of the function of the determiner 430.

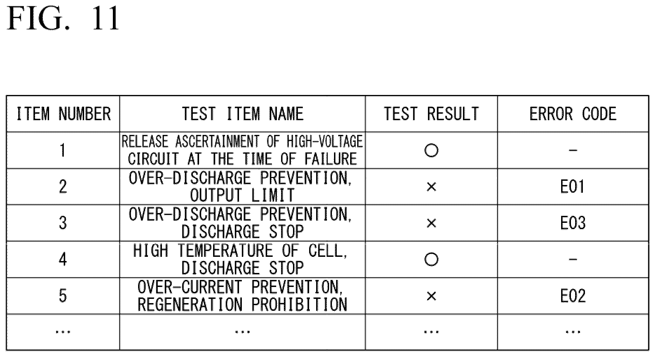

FIG. 11 is a diagram illustrating a test result of the adaptability test (the over-discharge test) in the example illustrated in FIG. 10. For example, FIG. 11 corresponds to the test item list 451 in the example illustrated in FIG. 6, in which the item number and the test item name of the corresponding test item are correlated with a test result and an error code of the corresponding item. For example, the item number "2" corresponds to Step S203 in the example illustrated in FIG. 10, and the error code "E01" is recorded in Step S208. The item number "5" corresponds to Step S204 in the example illustrated in FIG. 10, and the error code "E02" is recorded in Step S210. For example, the item number "3" corresponds to Step S206 in the example illustrated in FIG. 10, and the error code "E03" is recorded in Step S211.

In FIGS. 10 and 11, the over-discharge test of the detachable battery 100 is illustrated, but the adaptability test may be a test other than the over-discharge test. The test details may be arbitrarily defined by correlating the test item with set values associated with the determination in the same format as in the example illustrated in FIG. 6. In the details of the over-discharge test illustrated in FIG. 6, another over-discharge test may be defined by changing the set value.

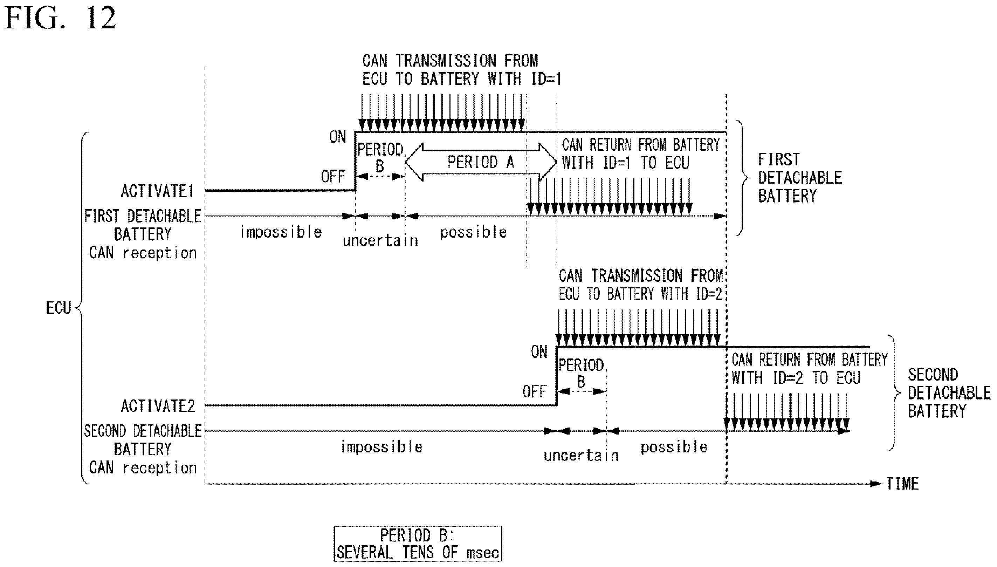

FIG. 12 is a diagram illustrating an example of a timing chart of signals that are input to and output from the monitoring device 400 at the time of testing of a plurality of detachable batteries 100. With the signal inputting and outputting method controlled in this way, the monitoring device 400 can decrease a delay due to replacement of the first signal with the second signal such that communication requirements between the target device TD and a detachable battery 100 are satisfied when a plurality of detachable batteries 100 are to be tested.

More specifically, in the adaptability test, the target device TD and a detachable battery 100 have to operate in synchronization with each other, and the synchronization should not be broken due to connection of the monitoring device 400 therebetween. In order to realize this, the first input/output unit 411 and the second input/output unit 412 in the monitoring device 400 according to this embodiment can read both an analog signal and a digital signal which are output from the target device TD and the detachable battery 100 and synchronize the devices.

For example, as illustrated in FIG. 12, the target device TD (ECU) transmits an analog signal ACTIVATE and a CAN signal for assigning an ID to the detachable battery 100. In this embodiment, when the monitoring device 400 is connected between the target device TD and the detachable battery 100, the monitoring device 400 is configured to appropriately read both signals. Accordingly, the monitoring device 400 can synchronize the target device TD and the detachable battery 100.

As illustrated in FIG. 12, CAN communication of the detachable battery 100 is electrically uncertain for several tens of msec (period B) after ACTIVATE for each detachable battery 100 has been turned on. Accordingly, in order to make sure assignment of an ID, the target device TD needs to turn on ACTIVATE of a first detachable battery 100A and needs to transmit an ID assignment command two or more times while a second detachable battery 100B is being activated (period A in the drawing) after the several tens of msec has elapsed. In order to ascertain whether the target device TD has appropriately performed this operation, the monitoring device 400 needs to synchronize the target device TD and the detachable battery 100 by synchronizing the ACTIVATE signal and the CAN signal. Transmission of the ID assignment command two or more times is for formally confirming reception of the ID assignment command through reception of two or more times in consideration of an influence of noise or the like.

The monitoring device 400 according to the aforementioned embodiment can more easily perform an adaptability test of a target device TD to a detachable battery 100 by receiving a first signal which is output from a detachable battery 100 out of a plurality of devices connected to a communication line to the communication line, replacing the received first signal with a second signal indicating an abnormality of the detachable battery 100 and transmitting the second signal to the target device TD other than the detachable battery 100 out of the plurality of devices, and determining an adaptability of the target device TD to the detachable battery 100 based on reception of a third signal which is transmitted by the target device TD in response to reception of the second signal or reception of a fourth signal indicating that the detachable battery 100 enters a desired operation state in response to reception of the third signal.

In this embodiment, a detachable battery 100 is used as a power source of an electric motorcycle 200, but usage of such a detachable battery 100 is not limited to this embodiment. The detachable battery 100 may be used as a power supply of various types of electric devices. Such an electric device may be a mobile object using an electric motor as a power source or may be a stationary power storage device. Examples of the mobile object include an automobile, a motorcycle, a standing ride type vehicle having a power unit, a ship, and a flying object. Examples of the automobile include a gasoline vehicle, a diesel vehicle, an electric vehicle, a fuel-cell vehicle, a hybrid vehicle, a small-sized commuter, and an electric cart. Examples of the motorcycle include a motorbike, a three-wheel motorcycle, and a motor-driven bicycle. Examples of the ship include a watercraft, a hovercraft, a water scooter, a submarine, an underwater craft, and an underwater scooter. Examples of the flying object include an aircraft, an airship or balloon, a hot-air balloon, a helicopter, and a drone.

The aforementioned embodiment can be expressed as follows:
a monitoring device comprising:
one or more storage media storing one or more computer-readable instructions; and
one or processors connected to the one or more storage media,
wherein the one or more processors execute the computer-readable instructions to perform:
   receiving a first signal which is output from a predetermined first device out of a plurality of devices connected to a communication line to the communication line;
   replacing the received first signal with a second signal indicating an abnormality of the first device and transmitting the second signal to a second device other than the first device out of the plurality of devices; and
   determining an adaptability of the second device to the first device based on reception of a third signal which is transmitted by the second device in response to reception of the second signal or reception of a fourth signal indicating that the first device enters a desired operation state in response to reception of the third signal.

While an embodiment of the present invention has been described above, the present invention is not limited to the embodiment and can be subjected to various modifications and substitutions without departing from the gist of the present invention.

### [Reference Signs List]

100, 100A, 100B Detachable battery
120 Power storage unit
131 Measuring sensor
132 Storage
140 Connection unit
200 Electric motorcycle
18 Vehicle sensor
20 HMI
22 GNSS receiver
210 Battery connection unit
220 Vehicle controller
230 Travel driving force output device
400 Monitoring device
411 First input/output unit
412 Second input/output unit
420 Detector
430 Determiner
440 Setter
450 Storage
451 Test item list
452 Replacement second signal
460 Display
470 Operation input unit
471 Cross key
472 Button
500 ECU

## Claims

1. A monitoring device comprising:
a receiver configured to receive a first signal which is output from a predetermined first device out of a plurality of devices connected to a communication line to the communication line;
a transmitter configured to replace the received first signal with a second signal indicating an abnormality of the first device and to transmit the second signal to a second device other than the first device out of the plurality of devices; and
a determiner configured to determine an adaptability of the second device to the first device based on reception of a third signal which is transmitted by the second device in response to reception of the second signal or reception of a fourth signal indicating that the first device enters a desired operation state in response to reception of the third signal.

2. The monitoring device according to claim 1, further comprising a storage configured to store a target signal which is a first signal to be replaced with the second signal in advance for each of a plurality of test items for simulating an abnormal state of the first device by replacing the first signal received from the first device with the second signal,
wherein the transmitter replaces the target signal with the second signal corresponding to a test item when the target signal for each test signal is received.

3. The monitoring device according to claim 2, wherein the storage stores a plurality of second signals with which the target signal is to be replaced for each test item and the third signal which is to be transmitted from the second device in response to reception of the second signal in advance, and
wherein the determiner determines that the second device is adaptable to the first device by receiving the third signal to be received from the second device for each test item.

4. The monitoring device according to any one of claims 1 to 3, wherein the first device is a battery and the second device is an electric device that operates with electric power supplied from the battery, and
wherein the determiner determines that the second device is adaptable to the first device when the second signal is a signal indicating an overloaded state of the battery and the third signal is a control signal for decreasing a load of the battery.

5. The monitoring device according to claim 2, further comprising a detector configured to detect an operation state of the first device,
wherein the storage stores an operation state suitable for the first device for each test item in advance, and the determiner determines that the second device is adaptable to the first device when the detector detects that the first device is in the suitable operation state for each test item.

6. A monitoring method that is performed by a computer, the monitoring method comprising:
receiving a first signal which is output from a predetermined first device out of a plurality of devices connected to a communication line to the communication line;
replacing the received first signal with a second signal indicating an abnormality of the first device and transmitting the second signal to a second device other than the first device out of the plurality of devices; and
determining an adaptability of the second device to the first device based on reception of a third signal which is transmitted by the second device in response to reception of the second signal or reception of a fourth signal indicating that the first device enters a desired operation state in response to reception of the third signal.

7. A program causing a computer to perform:
receiving a first signal which is output from a predetermined first device out of a plurality of devices connected to a communication line to the communication line;
replacing the received first signal with a second signal indicating an abnormality of the first device and transmitting the second signal to a second device other than the first device out of the plurality of devices; and
determining an adaptability of the second device to the first device based on reception of a third signal which is transmitted by the second device in response to reception of the second signal or reception of a fourth signal indicating that the first device enters a desired operation state in response to reception of the third signal.
